# EUROPÄISCHE PATENTSCHRIFT

(11) **EP 0 620 092 B1**
(45) Veröffentlichungstag und Bekanntmachung des Hinweises auf die Patenterteilung: **12.04.2000**
(21) Anmeldenummer: 94102351.7
(22) Anmeldetag: 17.02.1994
(51) Int. Cl.: B29C 33/38, C25D 1/10

(54) **Mikrostrukturkörper und Verfahren zu deren Herstellung**
Bodies having microstructure and process for the production thereof
Corps avec microstructure et son procédé de fabrication

(30) Priorität: 12.03.1993 DE 4307869
(43) Veröffentlichungstag der Anmeldung: 19.10.1994
(73) Patentinhaber: MICROPARTS GESELLSCHAFT FÜR MIKROSTRUKTURTECHNIK mbH, D-44227 Dortmund (DE)
(72) Erfinder: Lessmöllmann, Christoph, Dr., D-76593 Gernsbach (DE); Eicher, Joachim, Dr., D-44227 Dortmund (DE); Reinecke, Holger, Dr., D-44287 Dortmund (DE)

(56) Entgegenhaltungen:
- EP-A- 0 143 223
- EP-A- 0 224 630
- EP-A- 0 374 441
- EP-A- 0 547 371
- DE-A- 4 126 877

## Beschreibung

Die Erfindung betrifft Mikrostrukturkörper sowie ein Verfahren zum Herstellen von Mikrostrukturkörpern aus Metall, Kunststoff oder Sinterwerkstoff.

Mikrostrukturkörper haben Abmessungen im Mikrometerbereich; sie werden insbesondere in der Feinwerktechnik, Mikromechanik, Mikrooptik und Mikroelektronik benötigt, z. B. als Sensorelemente, Aktuatorelemente, Komponenten in fluidischen oder elektronischen Systemen. Sie werden im allgemeinen dort eingesetzt, wo Eigenschaften wie geringer Raumbedarf, niedriges Gewicht und kostengünstige Fertigung gefordert sind.

Die Erfindung bezweckt, derartige Mikrostrukturkörper wirtschaftlicher herzustellen.

Es ist bekannt, Mikrostrukturkörper aus Kunststoff, Metall oder Keramik nach dem LIGA-Verfahren durch Lithographie, Galvanoformung und Abformung herzustellen [Kernforschungszentrum Karlsruhe, Bericht 3995 (1985)]. Mikrostrukturkörper aus Kunststoff erhält man kostengünstig und in großen Stückzahlen durch Mehrfach-Abformen eines metallischen Formeinsatzes im Reaktions- oder Spritzguß-Verfahren.

Die Primärstruktur erhält man durch bildmäßiges Bestrahlen eines strahlungsempfindlichen Kunststoffs mittels Röntgenstrahlung oder Synchrotron-Strahlung und anschließendes Auflösen der bestrahlten (oder der unbestrahlten) Bereiche des Kunststoffes. Der Formeinsatz wird durch galvanisches Abscheiden von Metall in den zuvor aufgelösten Bereichen der Primärstruktur hergestellt. Die Struktur des Formeinsatzes ist komplementär zur Primärstruktur. Trotz aller Vorteile, die das LIGA-Verfahren bietet, wie z. B. weitgehende Geometriefreiheit in der Ebene oder die Vielfalt der einsetzbaren Materialien, sind in vielen Fällen einfachere Verfahren erwünscht.

Weiter ist bekannt, kristalline Materialien durch anisotropes Ätzen zu strukturieren (Proceedings of the IEEE, Vol. 70 (1982), No. 5 und IEEE-Trans. Electron. Devices ED-25 (1978), No. 10, 1178-1185). Die damit erhaltenen Mikrostrukturkörper sind nur selten unmittelbar verwendbar, weil das geätzte Material bestimmte Anforderungen - z. B. eine hinreichende Bruchfestigkeit - nicht erfüllt.

In EP - 0 143 223 A1 wird ein Doppelentformungsverfahren zur Herstellung von Trenndüsenstrukturen angegeben. Eine Urform aus Metall (das Werkzeug) wird röntgen-tiefenlithographisch hergestellt. Das Werkzeug wird gegen eine elektrisch leitfähige Substratplatte, die mit einem Kunststoff-Film beschichtet ist, gedrückt, wobei die Berührungsflächen des Werkzeugs mit der beschichteten Substratplatte abgedichtet werden. Die Strukturspalten des Werkzeugs werden mit einem Kunststoff aufgefüllt, der mit dem Kunststoff in der Schicht auf der Substratplatte eine innige Verbindung eingeht. Nach dem ersten Entformen des Werkzeugs vom Kunststoff werden die offenliegenden Bereiche des Kunststoff-Films auf der Substratplatte entfernt. Die leitfähigen Bereiche der Oberfläche der Substratplatte werden zur späteren Abformung der Positivform aus Metall passiviert. Die Hohlräume der Negativform aus Kunststoff auf der Substratplatte werden - ausgehend von den leitfähigen Bereichen der Substratplatte - galvanisch mit Metall aufgefüllt und mit einer geschlossenen Metallschicht überdeckt. In einer zweiten Entformung wird die Positivform aus Metall von der auf der Substratplatte haftenden Negativform aus Kunststoff getrennt. Die Negativform ist für mehrfaches galvanisches Abformen verwendbar.

In DE - 29 33 570 A ist ein Kunststoff-Kopierverfahren zur Herstellung von Trenndüsen beschrieben. Dabei wird ein Material mit energiereicher Strahlung partiell bestrahlt. Das in seinen Eigenschaften partiell veränderte Material wird durch Auflösen partiell entfernt. Dieses Verfahren beruht also ebenfalls auf Röntgen-Tiefenlithographie.

In DE - 41 26 877 C1 wird ein Verfahren zur Herstellung von Mikrostrukturkörpern aus Kunststoff beschrieben, bei dem ein Formteil aus Polymethyl-methacrylat durch Röntgen-Tiefenlithographie oder Abformen eines bereits vorhandenen mikrostrukturierten (metallischen) Mutterwerkzeugs erzeugt wird. Das Formteil wird unter Vakuum mit einem Reaktionsgießharz gefüllt und überschichtet, dessen Starttemperatur für die Polymerisationsreaktion unterhalb und dessen Härtetemperatur oberhalb der Erweichungstemperatur des Formteils liegt. Nach dem Aushärten des Reaktionsgießharzes wird das Formteil (als verlorene Form) mit einem Lösemittel aufgelöst.

EP - 0 224 630 A1 beschreibt ein Verfahren zum Herstellen plattenförmiger Mikrostrukturkörper aus Metall, bei dem Negativformen der Mikrostrukturen durch Abformen eines bereits vorhandenen Werkzeugs mit einer elektrisch isolierenden Abformmasse erzeugt werden. Diese Negativformen werden nach unterschiedlichen Verfahren mit einem leitfähigen Formboden versehen. Diese zusammenhängende Fläche dient als von außen kontaktierbare Elektrode. Die Negativformen werden galvanisch mit einem Metall aufgefüllt, wobei das galvanische Abscheiden des Metalls auf dem Formboden beginnt.

Damit stellt sich die Aufgabe, Mikrostrukturkörper aus Kunststoff, Sinterwerkstoff oder Metall durch Abformen eines mikrostrukturierten Formeinsatzes kostengünstiger und schneller herzustellen und die erreichbaren Strukturformen bei vertretbarem Aufwand zu erweitern. Die Struktur der Mikrostrukturkörper kann komplementär zur Struktur des Formeinsatzes sein oder sie kann mit der Struktur des Formeinsatzes übereinstimmen.

Die Aufgabe, Mikrostrukturkörper aus Kunststoff oder Sinterwerkstoff durch Abformen eines mikrostrukturierten Formeinsatzes herzustellen, wobei der Formeinsatz mit einem fließfähigen elektrisch nicht leitfähigen Material ausgefüllt und überdeckt wird, das fließfähige Material verfestigt wird und das verfestigte fließfähige Material von dem mikrostrukturierten Formeinsatz getrennt wird und der Mikrostrukturkörper erhalten wird, wird gelöst durch
- Verwenden eines Formeinsatzes (Primärstruktur) mit einseitig offenen Hohlräumen, der aus einem festen Körper durch Mikrostrukturieren - ausgenommen Röntgen-Tiefenlithographie - hergestellt worden ist, und dessen Struktur zur Struktur des Mikrostrukturkörpers komplementär ist.

Die Aufgabe, einen Mikrostrukturkörper aus Metall oder Sinterwerkstoff durch Abformen eines mikrostrukturierten Formeinsatzes herzustellen, wird gelöst durch die weiter unten angegebenen Verfahrensschritte.

Der verwendete mikrostrukturierte Formeinsatz (Primärstruktur) kann aus Metall (z.B. Messing, Aluminium, Stahl), Keramik (z.B. Aluminiumoxid, Porzellan, Hartmetall), Glas (z.B. Borsilikatglas, Claciumfluoridglas, Lithiumfluoridglas, Lithiumniobatglas) oder Stein (z.B. Edelstein wie Saphir, Rubin, Topas) - bevorzugt aus Silizium, Quarz, Galliumarsenid oder Germanium - als festem Körper bestehen. Die Primärstruktur kann hergestellt worden sein durch
- subtraktive Strukturierung mittels bildmäßigem Abtragen von Material von dem festen Körper, wie feinmechanische Präzisionsbearbeitung (Sägen, Schleifen, Fräsen, Bohren, gegebenenfalls mit Diamantwerkzeugen), Laserbearbeitung, Ionenätzen oder anisotropes Ätzen,
- oder durch additive Strukturierung mittel bildmäßigem Auftragen von Material auf den festen Körper, wie physikalisches oder chemisches Abscheiden von Material aus der Dampfphase (PVD oder CVD),
- oder durch additive und subtraktive Strukturierung.

Einkristallines Material (wie Silizium, Quarz oder Germanium) kann bevorzugt durch anisotropes Ätzen oder Ionenätzen strukturiert werden. Je nach den Eigenschaften des festen Körpers, auf dem die Primärstruktur hergestellt worden ist, können beide Verfahrensvarianten miteinander kombiniert werden.

Als fließfähiges Material zum Ausfüllen und Überdecken der Primärstruktur ist eine Reaktionsharz, das durch Aushärten verfestigt wird, oder ein geschmolzener Kunststoff, der durch Abkühlen verfestigt wird, geeignet. Weiter kann dafür ein pulverförmiges Material - bevorzugt ein Keramik-, Glas- oder Kunststoffpulver - oder eine Schlickermasse, die eines dieser Pulver enthält, verwendet werden. Das pulverförmige Material oder die Schlickermasse wird durch Trocknen, Sintern oder Brennen verfestigt.

Das verfestigte fließfähige Material wird durch Abheben von der Primärstruktur oder durch selektives Auflösen der Primärstruktur von dieser getrennt. Damit erhält man einen Mikrostrukturkörper aus Kunststoff oder Sinterwerkstoff, dessen Struktur zur Primärstruktur komplementär ist.

Durch feinmechanisches Abtragen der die Primärstruktur überdeckenden Schicht entsteht ein Mikrostrukturkörper aus Kunststoff oder Sinterwerkstoff mit durchgehenden Öffnungen. Je nach der strukturform kann die überdeckende Schicht vor oder nach dem Trennen des verfestigten fließfähigen Materials von der Primärstruktur abgetragen werden.

Zum Herstellen eines Mikrostrukturkörpers aus Metall, dessen Struktur mit der Primärstruktur übereinstimmt, wird nach dem Verfestigen des fließfähigen - elektrisch nicht leitfähigen - Materials die die Primärstruktur überdeckende Schicht bis zur Stirnseite der Primärstruktur durch feinmechanische Präzisionsbearbeitung abgetragen. Anschließend wird eine Deckschicht aufgetragen, die mit der Stirnseite der Primärstruktur in Kontakt steht. Diese Deckschicht besteht aus leitfähigem Material, z. B. leitfähigem Kunststoff oder Metall, oder aus einem Schichtverbund; dabei liegt auf der Stirnseite der Primärstruktur eine dünne Metallschicht und darüber eine dicke Kunststoffschicht. Nun wird das verfestigte fließfähige Material mit der Deckschicht - bevorzugt durch Abheben - von der Primärstruktur getrennt, womit man die Sekundärstruktur erhält, die zur Primärstruktur komplementär ist. Diese Sekundärstruktur wird mit einem galvanisch oder chemisch abgeschiedenen Metall - wie Nickel, Kupfer oder Gold - ausgefüllt und überdeckt. Die mikrostrukturierte Schicht wird von der Sekundärstruktur - bevorzugt durch Abheben - getrennt, wobei der metallische Mikrostrukturkörper erhalten wird, dessen Struktur mit der Primärstruktur übereinstimmt, der jedoch aus einem anderen Metall als die Primärstruktur besteht.

Dieser metallische Mikrostrukturkörper kann als solcher verwendet werden. Andererseits kann man ihn (als Tertiärstruktur) zum Abformen von Mikrostrukturkörpern benutzen, deren Struktur zur Primärstruktur komplementär ist.

Zum Herstellen der Primärstruktur wird ein Material gewählt, dessen Eigenschaften die für die angegebenen Strukturierungsverfahren zu stellenden Anforderungen möglichst gut erfüllen. Dazu gehören
- die möglichst gratfreie Strukturierbarkeit bei feinmechanischer Präzisionsbearbeitung,
- spiegelglatte Oberflächen der erzeugten Mikrostrukturen,
- möglichst hohe Materialhomogenität und Reinheit,
- ausreichende Dimensionsstabilität und mechanische Festigkeit für die Strukturierung und die nachfolgenden Verfahrensschritte,
- selektive Ätzbarkeit gegenüber den anderen beim Ätzen anwesenden Stoffen.

Besonders geeignet sind vergleichsweise dicke Scheiben eines einkristallinen Materials - bevorzugt aus Silizium, Quarz, Galliumarsenid oder Germanium -, die in großen Mengen in der Mikroelektronik eingesetzt werden sowie leicht und kostengünstig erhältlich sind. Daneben sind Scheiben oder gegebenenfalls andere Körper (wie Zylinder) aus Glas, Keramik, Stein oder anderen Metallen geeignet, wenn sie die für das beabsichtigte Strukturierungsverfahren zu stellenden Anforderungen erfüllen.

Aus Stabilitätsgründen werden etwa 2 mm dicke Scheiben bevorzugt, die auf einer Seite in der oben angegebenen Weise strukturiert werden. Wenn die Primärstruktur später von der Sekundärstruktur oder dem Mikrostrukturkörper durch Abheben getrennt werden soll, muß die Primärstruktur frei sein von Hinterschneidungen, sich verengenden Hohlräumen, Graten und rauhen Seitenflächen, da dadurch das Abheben erschwert oder verhindert wird. Falls die Primärstruktur Hinterschneidungen oder Verengungen enthält, wird die Primärstruktur aufgelöst und dadurch von der Sekundärstruktur getrennt.

Die Primärstruktur wird bevorzugt mit einem thermoplastischen Kunststoff oder einem Reaktionsharz ausgefüllt und überdeckt. Besonders geeignet ist Polymethylmethacrylat wegen seiner guten Fließeigenschaften und seiner ausreichenden chemischen und mechanischen Stabilität für die nachfolgenden Verfahrensschritte. Pulverförmiges fließfähiges Material oder eine Schlickermasse wird in die Primärstruktur gegossen oder mechanisch eingepreßt, gegebenenfalls unter Anlegen eines Unterdruckes.

Die die Primärstruktur überdeckende Schicht ermöglicht oder erleichtert den Trennvorgang und kann Bestandteil des Mikrostrukturkörpers mit einseitig offenen Hohlräumen sein. Durch mechanisches Abtragen der Deckschicht entstehen einerseits Mikrostrukturkörper mit durchgehenden Öffnungen, wie Sieb- und Netz-Strukturen. Andererseits wird die die Primärstruktur überdeckende Schicht mechanisch abgetragen, und eine Schicht aus elektrisch leitfähigem Material wird aufgetragen, wenn die Mikrostruktur aus verfestigtem fließfähigem Material anschließend z. B. durch Galvanoformung in eine metallische Mikrostruktur umkopiert werden soll. Für die Galvanoformung von Mikrostrukturen mit großem Aspektverhältnis sind im allgemeinen Hohlräume erforderlich, deren Seitenwände nicht leitfähig sind, damit das galvanisch abgeschiedene Metall nur von der leitfähigen Bodenschicht aus hochwächst. Andere Strukturformen - wie Pyramidenstrukturen - werden auch bei leitfähigen Seitenwänden durch Galvanoformung vollständig ausgefüllt.

Die leitfähige Schicht besteht beispielsweise aus einem leitfähigen Kunststoff oder Klebstoff oder aus Metall. Thermoplastisch verarbeitbare leitfähige Kunststoffe enthalten einen zum Beispiel leitfähigen Füllstoff; diese werden z. B. zu Platten verarbeitet, die mit dem verfestigten fließfähigen Material, das die Hohlräume der Primärstruktur ausfüllt, verschweißt oder verklebt werden.

Kunststoffe mit intrinsischer Leitfähigkeit, z. B. Polypyrrol, Polyacetylen, Polythiophen, sind als leitfähige Startschicht ebenfalls verwendbar.

Eine leitfähige Schicht aus Metall wird z. B. durch Bedampfen mit Metall bei relativ niedriger Temperatur erzeugt. Für die Galvanoformung ist eine sehr dünne Metallschicht hinreichend, die durch Bedampfen leicht herzustellen ist.

Um die mechanische Stabilität zu verbessern, wird die dünne Metallschicht z. B. mit einer Kunststoffplatte verklebt oder durch galvanische Abscheidung von Metall verstärkt.

Die leitfähige Deckschicht muß direkten Kontakt mit den Stirnseiten der Primärstruktur haben, damit nach dem Trennvorgang Hohlräume mit einer leitfähigen Bodenschicht vorliegen.

Zum Trennen der Primärstruktur von dem verfestigten fließfähigem Material ist es bei vielen Strukturen möglich, das verfestigte fließfähige Material von der Primärstruktur abzuheben, vor allem dann, wenn das verfestigte fließfähige Metall hinreichend eigenstabil ist, nur schwach an der Primärstruktur haftet und diese keine Hinterschneidungen oder Verengungen hat. Bei dieser Art des Trennens bleibt die Primärstruktur erhalten und kann wiederholt mit fließfähigem Material ausgefüllt und über-deckt werden, d. h. sie kann wiederholt zum Herstellen von Mikrostrukturkörpern oder zum Herstellen der Sekundärstruktur verwendet werden.

Andererseits kann die Primärstruktur von dem verfestigten fließfähigem Material durch chemisches Auflösen der Primärstruktur, die dann verloren ist, getrennt werden. Primärstrukturen aus kristallinem Material werden von basischen Ätzmitteln oder Salzen angegriffen, gegen die etliche Metalle und Kunststoffe resistent sind.

Natronlauge oder Kalilauge sind geeignete Ätzmittel für Silizium. Natronlauge mit Wasserstoffperoxid ist ein geeignetes Ätzmittel für Galliumarsenid. Ammoniumbifluorid ist ein geeignetes Ätzmittel für Quarz, und eine Mischung aus Wasserstoffperoxid und Phosphaten ist ein geeignetes Ätzmittel für Germanium.

Zum vollständigen Auflösen von Silizium ist z. B. eine 18%ige Kalilaugelösung bei 70 °C geeignet. Polymethylmethacrylat und Metalle sind gegen dieses Lösemittel beständig.

Eine Sekundärstruktur mit leitfähiger Bodenschicht oder Bodenplatte kann durch Galvanoformung nochmals umkopiert werden. Dabei erhält man einen metallischen Mikrostrukturkörper, dessen Struktur mit der Primärstruktur übereinstimmt, der aber aus einem anderen Metall als die Primärstruktur besteht. Dieser Körper kann das gewünschte Endprodukt sein.

Andererseits kann diese Mikrostruktur (Tertiärstruktur) als Formeinsatz zum wiederholten Abformen eines Mikrostrukturkörpers dienen, dessen Struktur zur Primärstruktur komplementär ist.

Einige der angegebenen Verfahrensschritte können miteinander vertauscht werden, wodurch der Verfahrensablauf variiert werden kann.

Das erfindungsgemäße Verfahren und die damit hergestellten Mikrostrukturkörper haben folgende Vorteile:
- Zum Herstellen eines Mikrostrukturkörpers werden im einfachen Fall nur zwei wesentliche Verfahrensschritte benötigt, nämlich die Strukturierung des festen Körpers durch Präzisionsbearbeitung, additive Strukturierung oder subtraktive Strukturierung sowie das Ausfüllen und Überdecken der Primärstruktur mit einem fließfähigen Material.
- Das Verfahren wird ohne Röntgen-Tiefen-Lithographie durchgeführt; dadurch entfallen längere aufwendige Bestrahlungszeiten.
- Zum Herstellen der Primär-, Sekundär- oder Tertiärstruktur werden Werkstoffe ausgewählt, die für diese Verfahrensschritte optimal sind; Anforderungen, die an den Mikrostrukturkörper gestellt werden, bleiben hierbei unberücksichtigt.
- Für den Mikrostrukturkörper werden Werkstoffe ausgewählt, die die gestellten Anforderungen optimal erfüllen; Anforderungen, die während der Herstellung der Primär-, Sekundär- oder Tertiärstruktur gestellt werden, haben keinen Einfluß mehr.
- Die Mikrostrukturen können bereichsweise unterschiedliche Höhe haben.
- Neben den durch Röntgen-Tiefenlithographie erhältlichen Strukturformen werden weitere Formen zugänglich, die schnell und kostengünstig gefertigt werden können.
- Mikrostrukturen mit gegeneinander geneigten oder gekrümmten Wänden sind auf einfache Weise und mit wenig Aufwand herstellbar.
- Der beim Verfestigen des fließfähigen Materials gegebenenfalls auftretende Volumenschwund wird durch die Deckschicht auf der Primär- oder Sekundärstruktur ausgeglichen.

Das erfindungsgemäße Verfahren wird an Hand der Figuren weiter erläutert.

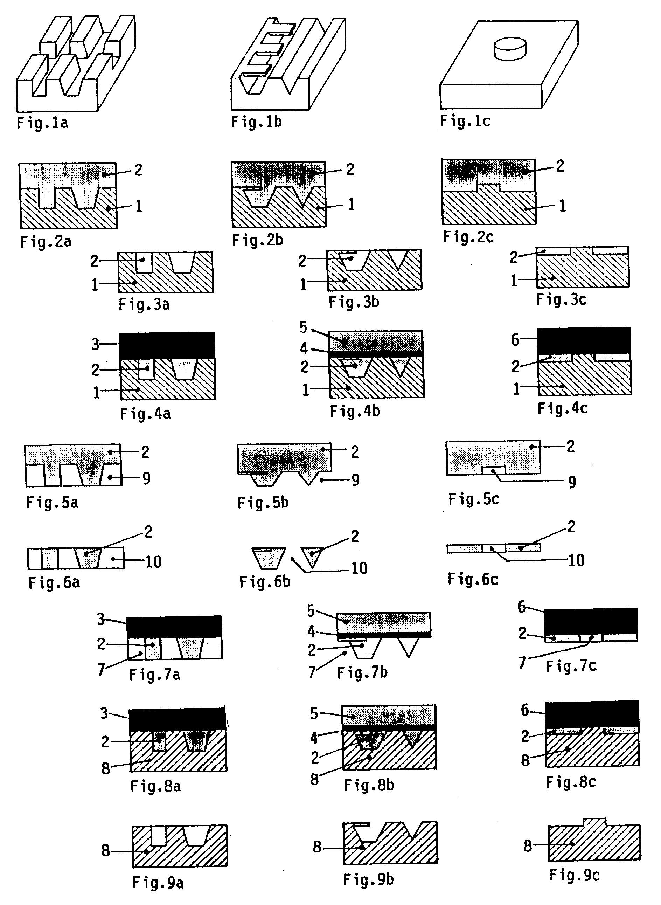

Figur 1 zeigt drei Beispiele für die aus einem festen Körper hergestellte Primärstruktur jeweils in Schrägansicht. Die Mikrostruktur in Figur 1 a wird durch feinmechanische Präzisionsbearbeitung erhalten, die in Figur 1 b durch subtraktives Strukturieren und die in Figur 1 c durch additives Strukturieren. Figuren 2 a, b, c zeigen im Querschnitt die mit einem fließfähigen Material (2) ausgefüllte und überdeckte Mikrostruktur (1), die anschließend in unterschiedlicher Weise weiterbearbeitet werden kann.

Einerseits kann die Deckschicht bis auf die Stirnseite der Primärstruktur abgetragen werden. Dabei entstehen die in den Figuren 3 a, b, c gezeigten mit fließfähigem Material (2) ausgefüllten Primärstrukturen (1). Durch Überdecken mit einer leitfähigen Schicht entstehen die in Figur 4 a, b, c gezeigten Strukturen. In Figur 4 a ist eine relativ dicke Deckschicht (3) aus leitfähigem Kunststoff dargestellt, in Figur 4 b ein Schichtverbund, bestehend aus einer dünnen Metallschicht (4) unmittelbar auf der Stirnseite der Primärstruktur und einer darüberliegenden relativ dicken Schicht (5) aus nicht leitfähigem Kunststoff, in Figur 4 c ist eine relativ dicke Metallschicht (6) dargestellt.

Nun wird die Primärstruktur von der Sekundärstruktur getrennt, bei den Strukturen nach Figur 4 a und Figur 4 c z. B. durch Abheben, bei der Struktur nach Figur 4 b z. B. durch Auflösen der Primärstruktur. Dadurch entstehen die bei den Figuren 7 a, b, c dargestellten Strukturen, bestehend aus einer auf der Stirnseite der Primärstruktur liegenden leitfähigen Schicht (3), (4) oder (6) und dem strukturierten verfestigten fließfähigen Material (2), das die Hohlräume der Primärstruktur ausgefüllt hat. In Figur 7 b ist die dünne leitfähige Schicht (4) durch eine relativ dicke Schicht (5) verstärkt.

Falls sich die Primärstruktur von der Sekundärstruktur abheben läßt, kann die Primärstruktur wiederholt zur Herstellung der Sekundärstruktur verwendet werden.

Die Hohlräume (7) der Sekundärstrukturen nach den Figuren 7 a, b, c werden z. B. durch Galvanoformung mit Metall (8) ausgefüllt und überdeckt; die Figuren 8 a, b, c zeigen die Schichtenfolge.

Die Mikrostruktur aus Metall wird von der Sekundärstruktur getrennt; dabei entstehen die in den Figuren 9 a, b, c gezeigten Mikrostrukturkörper aus Metall. Die in den Figuren 8 a und 8 c dargestellten Strukturen können durch Abheben getrennt werden. Bei der Struktur nach Figur 8 b werden die beiden Deckschichten (4) und (5) und das aus der Primärstruktur stammende verfestigte fließfähige Material (2) aufgelöst.

Die in den Figuren 9 a, b, c dargestellten erfindungsgemäßen metallischen Mikrostrukturkörper werden der Verwendung zugeführt, oder sie dienen z. B. bei den Figuren 9 a und 9 c als Formeinsatz zum Abformen von komplementären Mikrostrukturkörpern.

Andererseits können die in den Figuren 2 a, b, c dargestellten Strukturen voneinander getrennt werden, wobei die in den Figuren 5 a, b, c dargestellten Strukturen aus verfestigtem fließfähigen Material (2) erhalten werden. Zum Trennen des in Figur 2 b dargestellten Verbundkörpers wird der die Primärstruktur bildende feste Körper (1) aufgelöst.

Die in den Figuren 5 a, b, c dargestellten Mikrostrukturen aus Kunststoff oder Sinterwerkstoff, bzw. die in den Figuren 9 a, 9 b, 9 c dargestellten Mikrostrukturen aus Metall oder Sinterwerkstoff haben einseitig offene Hohlräume (9) und sind die erfindungsgemäßen Mikrostrukturkörper.

Weiter kann die Deckschicht aus verfestigtem fließfähigen Material von den Mikrostrukturen nach den Figuren 5 a, b, c mechanisch abgetragen werden. Dadurch entstehen die in den Figuren 6 a, b, c gezeigten erfindungsgemäßen Mikrostrukturkörper, die in dem hier gezeigten Beispiel aus Kunststoff oder Sinterwerkstoff bestehen, mit durchgehenden Öffnungen (10).

### Beispiel

Ein Mikrostrukturkörper aus Nickel mit einseitig offenen Hohlräumen wird z. B. folgendermaßen hergestellt.

Eine polierte Scheibe aus Silizium (2 mm dick, 100 mm Durchmesser) wird durch Sägen mittels eines 70 µm dicken Diamantsägeblattes strukturiert. Die Mikrostruktur besteht aus quadratischen Säulen (140 µm breit in jeder Richtung, 600 µm hoch). Anschließend wird die runde Scheibe mit einem gröberen Sägeblatt in mehrere rechteckige Stücke zerteilt.

Die Siliziumscheibe mit der Primärstruktur wird gereinigt und auf einen Metallträger geklebt; dieser wird in das Werkzeug einer Reaktionsgießmaschine eingebaut. Die Primärstruktur wird unter Anlegen eines Unterdruckes vollständig mit Polymethylmethacrylat gefüllt und mit einer etwa 2 mm dicken Schicht überdeckt; der Kunststoff härtet innerhalb von wenigen Minuten aus.

Der Metallträger mit der aufgeklebten und gefüllten Primärstruktur wird aus der Gießmaschine entnommen. Die die Primärstruktur überdeckende Schicht wird durch Fräsen abgetragen, wobei die Stirnseite der Siliziumscheibe freigelegt wird.

Auf die Stirnseite der strukturierten Siliziumscheibe wird eine leitfähige Schicht aus Titan und Titanoxid aufgedampft und mit einem Kontaktdraht versehen. Auf die leitfähige Schicht wird eine Trägerplatte aus Polymethylmethacrylat aufgeklebt. Die Primärstruktur wird von der Sekundärstruktur durch Abheben getrennt.

In den Hohlräumen der Sekundärstruktur wird - ausgehend von der leitfähigen Schicht am Boden jedes Hohlraumes - Nickel galvanisch abgeschieden. Die mit Nickel gefüllten Hohlräume werden mit einer mehrere Millimeter dicken Nickelschicht als formstabiler Trägerschicht überdeckt. Die Sekundärstruktur wird von dem Mikrostrukturkörper aus Nickel durch Abheben getrennt. Mit dieser Sekundärstruktur werden weitere Mikrostrukturkörper aus Kunststoff hergestellt.

## Patentansprüche

1. Verfahren zum Herstellen eines Mikrostrukturkörpers aus Kunststoff oder Sinterwerkstoff durch Abformen eines mikrostrukturierten Formeinsatzes, wobei der Formeinsatz mit einem fließfähigen elektrisch nicht leitfähigem Material ausgefüllt und überdeckt wird, das fließfähige Material verfestigt wird und das verfestigte fließfähige Material von dem mikrostrukturierten Formeinsatz getrennt und der Mikrostrukturkörper erhalten wird, gekennzeichnet durch
- Verwenden eines Formeinsatzes (Primärstruktur) mit einseitig offenen Hohlräumen, der aus einem festen Körper durch Mikrostrukturieren - ausgenommen durch Röntgen-Tiefenlithographie - hergestellt worden ist und dessen Struktur zur Struktur des Mikrostrukturkörpers komplementär ist.

2. Verfahren nach Anspruch 1, gekennzeichnet durch
- Verwenden eines mikrostrukturierten Formeinsatzes (Primärstruktur) aus Metall, Keramik, Glas oder Stein - bevorzugt aus Silizium, Quarz, Galliumarsenid oder Germanium - als festem Körper, der
- durch subtraktive Strukturierung mittels bildmäßigem Abtragen von Material wie feinmechanische Präzisionsbearbeitung, Laserbearbeitung, Ionenätzen oder anisotropes Ätzen,
- oder durch additive Strukturierung mittels bildmäßigem Auftragen von Material - wie physikalisches oder chemisches Abscheiden von Material aus der Dampfphase auf dem festen Körper,
- oder durch additive und subtraktive Strukturierung hergestellt worden ist.

3. Verfahren nach den Ansprüchen 1 und 2, gekennzeichnet durch
- Ausfüllen und Überdecken der Primärstruktur mit einem Reaktionsharz oder einem geschmolzenen Kunststoff als fließfähigem Material und
- Verfestigen des Reaktionsharzes durch Aushärten oder des geschmolzenen Kunststoffes durch Abkühlen.

4. Verfahren nach den Ansprüchen 1 und 2, gekennzeichnet durch
- Ausfüllen und Überdecken der Primärstruktur mit einem pulverförmigen Material - bevorzugt einem Keramik- oder Glaspulver - oder einer Schlickermasse, die eines dieser Pulver enthält,
- Verfestigen des pulverförmigen Materials oder der Schlickermasse durch Trocknen, Sintern oder Brennen.

5. Verfahren nach den Ansprüchen 1 bis 4, gekennzeichnet durch
- Trennen des verfestigten fließfähigen Materials von der Primärstruktur durch
- Abheben des verfestigten fließfähigen Materials von der Primärstruktur, oder durch
- selektives Auflösen der Primärstruktur.

6. Verfahren nach den Ansprüchen 1 bis 5, gekennzeichnet durch
- Abtragen der die Primärstruktur überdeckenden Schicht nach dem Trennen des verfestigten fließfähigen Materials von der Primärstruktur, wobei der Mikrostrukturkörper aus Kunststoff oder Sinterwerkstoff mit durchgehenden Öffnungen entsteht.

7. Verfahren nach Anspruch 1 zum Herstellen von Mikrostrukturkörpern aus Metall oder Sinterwerkstoff durch Abformen eines Formeinsatzes, wobei ein Mikrostrukturkörper erhalten wird, dessen Struktur mit der Struktur des Formeinsatzes übereinstimmt, gekennzeichnet durch folgende weiteren Schritte im Anschluß an das Verfestigen des fließfähigen elektrisch nicht leitfähigen Materials in der Primärstruktur,
- Abtragen der die Primärstruktur überdeckenden Schicht bis zur Stirnseite der Primärstuktur,
- Auftragen einer Deckschicht aus leitfähigem Material, die mit der Stirnseite der Primärstruktur in Kontakt steht,
- Trennen des verfestigten fließfähigen Materials mit Deckschicht von der Primärstruktur, wobei eine Mikrostruktur (Sekundärstruktur) erhalten wird, die zur Primärstruktur komplementär ist,
- Ausfüllen und Überdecken der Sekundärstruktur mit einem Metall oder Sinterwerkstoff und Verfestigen des Sinterwerkstoffs.

8. Verfahren nach Anspruch 7, gekennzeichnet durch
- Verwenden eines mikrostrukturierten Formeinsatzes (Primärstruktur) aus Metall, - bevorzugt aus Messing, Aluminium oder Stahl - als festem Körper, der
- durch subtraktive Strukturierung mittels bildmäßigem Abtragen von Material wie feinmechanische Präzisionsbearbeitung oder Laserbearbeitung, Ionenätzen oder anisotropes Ätzen,
- oder durch additive Strukturierung mittels bildmäßigem Auftragen von Material wie physikalisches oder chemisches Abscheiden von Material aus der Dampfphase auf dem festen Körper,
- oder durch additive und subtraktive Strukturierung hergestellt worden ist.

9. Verfahren nach den Ansprüchen 7 und 8, gekennzeichnet durch
- Ausfüllen und Überdecken der Primärstruktur mit einem Reaktionsharz oder einem geschmolzenen Kunststoff als fließfähigem Material und
- Verfestigen des Reaktionsharzes durch Aushärten oder des geschmolzenen Kunststoffes durch Abkühlen.

10. Verfahren nach den Ansprüchen 7 und 8, gekennzeichnet durch
- Ausfüllen und Überdecken der Primärstruktur mit einem pulverförmigen Material - bevorzugt einem Keramik- oder Glaspulver - oder einer Schlickermasse, die eines dieser Pulver enthält,
- Verfestigen des pulverförmigen Materials oder der Schlickermasse durch Trocknen, Sintern oder Brennen.

11. Verfahren nach den Ansprüchen 7 bis 10, gekennzeichnet durch
- Trennen des verfestigten fließfähigen Materials von der Primärstruktur durch
- Abheben des verfestigen fließfähigen Materials von der Primärstruktur, oder durch
- selektives Auflösen der Primärstruktur.

12. Verfahren nach den Ansprüchen 7 bis 11, gekennzeichnet durch
- Trennen der mikrostrukturierten Schicht aus abgeschiedenem Metall von der Sekundärstruktur durch
- Abheben der strukturierten Metallschicht von der Sekundärstruktur, oder
- selektives Auflösen der Deckschicht aus leitfähigem Material und der Teile des verfestigten fließfähigen Materials, das die Primärstruktur ausgefüllt hat.

13. Verfahren nach Anspruch 12, gekennzeichnet durch
- Verwenden eines Formeinsatzes (Primärstruktur) aus Metall
- bevorzugt aus Messing, Aluminium oder Stahl - mit einseitig offenen Hohlräumen, der durch subtraktive Strukturierung mittels bildmäßigem Abtragen von Material hergestellt worden ist.

14. Verfahren nach den Ansprüchen 12 und 13, gekennzeichnet durch
- Verwenden eines Formeinsatzes (Primärstruktur) aus Metall
- bevorzugte aus Messing, Aluminium oder Stahl - mit einseitig offenen Hohlräumen, der
- durch feinmechanische Präzisionsbearbeitung wie Sägen, Schleifen, Fräsen, Bohren hergestellt worden ist.

15. Verfahren nach den Ansprüchen 12 und 13, gekennzeichnet durch
- Verwenden eines Formeinsatzes (Primärstruktur) aus Metall
- bevorzugt aus Messing, Aluminium oder Stahl - mit einseitig offenen Hohlräumen, der
- durch Ionenätzen oder durch anisotropes Ätzen aus einem einkristallinen Material als festem Körper hergestellt worden ist.

16. Verfahren nach den Ansprüchen 12 und 13, gekennzeichnet durch
- Verwenden eines Formeinsatzes (Primärstruktur) aus Metall
- bevorzugt aus Messing, Aluminium oder Stahl - mit einseitig offenen Hohlräumen, der
- durch Laserbearbeitung hergestellt worden ist.

17. Verfahren nach Anspruch 12, gekennzeichnet durch
- Verwenden eines Formeinsatzes (Primärstruktur) aus Metall
- bevorzugt aus Messing, Aluminium oder Stahl - mit einseitig offenen Hohlräumen, der durch additive Strukturierung mittels bildmäßigem Auftragen von Material hergestellt worden ist.

18. Verfahren nach den Ansprüchen 12 und 17, gekennzeichnet durch
- Verwenden eines Formeinsatzes (Primärstruktur) aus Metall
- bevorzugt aus Messing, Aluminium oder Stahl - mit einseitig offenen Hohlräumen, der durch physikalisches oder chemisches Abscheiden von Material aus der Dampfphase auf dem festen Körper hergestellt worden ist.

19. Verfahren nach den Ansprüchen 12 und 17, gekennzeichnet durch
- Verwenden eines Formeinsatzes (Primärstruktur) aus Metall
- bevorzugt aus Messing, Aluminium oder Stahl - mit einseitig offenen Hohlräumen, der durch additive und subtraktive Strukturierung hergestellt worden ist.

20. Verfahren nach den Ansprüchen 13 und 17, gekennzeichnet durch
- Ausfüllen und Überdecken der Primärstruktur mit einem Reaktionsharz oder einem geschmolzenen Kunststoff als fließfähigem Material und
- Verfestigen des Reaktionsharzes durch Aushärten oder des geschmolzenen Kunststoffes durch Abkühlen.

21. Verfahren nach den Ansprüchen 13 und 17, gekennzeichnet durch
- Ausfüllen und Überdecken der Primärstruktur mit einem pulverförmigen Material - bevorzugt einem Metall-, Keramik- oder Glaspulver - oder einer Schlickermasse, die eines dieser Pulver enthält,
- Verfestigen des pulverförmigen Materials oder der Schlickermasse durch Trocknen, Sintern oder Brennen.

22. Verfahren nach den Ansprüchen 13 und 17, gekennzeichnet durch
- Trennen des verfestigten fließfähigen Materials von der Primärstruktur durch
- Abheben des verfestigen fließfähigen Materials von der Primärstruktur, oder durch
- selektives Auflösen der Primärstruktur.

23. Verfahren nach den Ansprüchen 15 und 17, gekennzeichnet durch
- Trennen der mikrostrukturierten Schicht aus galvanisch abgeschiedenem Metall von der Sekundärstruktur durch
- Abheben der strukturierten Metallschicht von der Sekundärstruktur, oder
- selektives Auflösen der Deckschicht aus leitfähigem Material und der Teile des verfestigten fließfähigen Materials, das die Primärstruktur ausgefüllt hat.

## Claims

1. A process for the production of a microstructure element from plastics or sintered material by casting from a microstructured mould insert, the mould insert being filled and covered with a flowable electrically non-conductive material, the flowable material being solidified and the solidified flowable material being separated from the microstructured mould insert, giving the microscructure element, characterized by
- use of a mould insert (primary structure) having cavities open on one side, which mould insert has been produced from a solid body by microstructuring - other than by deep X-ray lithography - and whose structure is complementary to the structure of the microstructure element.

2. A process according to claim 1, characterized by
- use of a microstructured mould insert (primary structure) made of metal, ceramic, glass or mineral - preferably made of silicon, quartz, gallium arsenide or germanium - as solid body which has been produced
- by subtractive structuring by means of imagewise removal of material such as precision mechanical machining, laser machining, ion etching or anisotropic etching,
- or by additive structuring by means of imagewise application of material - such as physical or chemical deposition of material from the vapour phase onto the solid body,
- or by additive and subtractive structuring.

3. A process according to either of claims 1 and 2, characterized by
- filling and covering of the primary structure with a reaction-curable resin or a molten plastics material as the flowable material and
- solidification of the reaction-curable resin by curing or of the molten plastics material by cooling.

4. A process according to either of claims 1 and 2, characterized by
- filling and covering of the primary structure with a pulverulent material - preferably a ceramic or glass powder - or a slip composition containing one of these powders,
- solidification of the pulverulent material or of the slip composition by drying, sintering or firing.

5. A process according to any of claims 1 to 4, characterized by
- separation of the solidified flowable material from the primary structure by
- lifting-off of the solidified flowable material from the primary structure, or by
- selective dissolution of the primary structure.

6. A process according to any of claims 1 to 5, characterized by
- removal of the layer covering the primary structure from the primary structure after separation of the solidified flowable material, giving the plastics material or sintered material microstructure element with through-apertures.

7. A process according to claim 1 for the production of microstructure elements from metal or sintered material by casting from a mould insert, giving a microstructure element whose structure corresponds to the structure of the mould insert, characterized by the following further steps after the solidification of the flowable electrically non-conductive material in the primary structure,
- removal of the layer covering the primary structure as far as the front face of the primary structure,
- application of a top layer of conductive material which is in contact with the front face of the primary structure,
- separation of the solidified flowable material with top layer from the primary structure, giving a microstructure (secondary structure) which is complementary to the primary structure,
- filling and covering of the secondary structure with a metal or sintered material and solidification of the sintered material.

8. A process according to claim 7, characterized by
- use of a microstructured mould insert (primary structure) made of metal - preferably made of brass, aluminium or steel - as the solid body which has been produced
- by subtractive structuring by means of imagewise removal of material such as precision mechanical machining or laser machining, ion etching or anisotropic etching,
- or by additive structuring by means of imagewise application of material such as physical or chemical deposition of material from the vapour phase onto the solid body,
- or by additive and subtractive structuring.

9. A process according to either of claims 7 and 8, characterized by
- filling and covering of the primary structure with a reaction-curable resin or a molten plastics material as the flowable material and
- solidification of the reaction-curable resin by curing or of the molten plastics material by cooling.

10. A process according to either of claims 7 and 8, characterized by
- filling and covering of the primary structure with a pulverulent material - preferably a ceramic or glass powder - or a slip composition containing one of these powders,
- solidification of the pulverulent material or of the slip composition by drying, sintering or firing.

11. A process according to any of claims 7 to 10, characterized by
- separation of the solidified flowable material from the primary structure by
- lifting-off of the solidified flowable material from the primary structure, or by
- selective dissolution of the primary structure.

12. A process according to any of claims 7 to 11, characterized by
- separation of the microstructured layer of deposited metal from the secondary structure by
- lifting-off of the structured metal layer from the secondary structure, or
- selective dissolution of the top layer of conductive material and of the parts of the solidified flowable material which the primary structure has filled.

13. A process according to claim 12, characterized by
- use of a mould insert (primary structure) made of metal
- preferably made of brass, aluminium or steel - having cavities open on one side, which has been produced by subtractive structuring by means of imagewise removal of material.

14. A process according to either of claims 12 and 13, characterized by
- use of a mould insert (primary structure) made of metal
- preferably made of brass, aluminium or steel - having cavities open on one side, which
- has been produced by precision mechanical machining such as sawing, grinding, milling or drilling.

15. A process according to either of claims 12 and 13, characterized by
- use of a mould insert (primary structure) made of metal
- preferably made of brass, aluminium or steel - having cavities open on one side, which
- has been produced by ion etching or by anisotropic etching from a monocrystalline material as solid body.

16. A process according to either of claims 12 and 13, characterized by
- use of a mould insert (primary structure) made of metal
- preferably made of brass, aluminium or steel - having cavities open on one side, which
- has been produced by laser machining.

17. A process according to claim 12, characterized by
- use of a mould insert (primary structure) made of metal
- preferably made of brass, aluminium or steel - having cavities open on one side, which has been produced by additive structuring by means of imagewise application of material.

18. A process according to either of claims 12 and 17, characterized by
- use of a mould insert (primary structure) made of metal
- preferably made of brass, aluminium or steel - having cavities open on one side, which has been produced by physical or chemical deposition of material from the vapour phase onto the solid body.

19. A process according to either of claims 12 and 17, characterized by
- use of a mould insert (primary structure) made of metal
- preferably made of brass, aluminium or steel - having cavities open an one side, which has been produced by additive and subtractive structuring.

20. A process according to either of claims 13 and 17, characterized by
- filling and covering of the primary structure with a reaction-curable resin or a molten plastics material as the flowable material and
- solidification of the reaction-curable resin by curing or of the molten plastics material by cooling.

21. A process according to either of claims 13 and 17, characterized by
- filling and covering of the primary structure with a pulverulent material - preferably a metal, ceramic or glass powder - or a slip composition containing one of these powders,
- solidification of the pulverulent material or of the slip composition by drying, sintering or firing.

22. A process according to either of claims 13 and 17, characterized by
- separation of the solidified flowable material from the primary structure by
- lifting-off of the solidified flowable material from the primary structure, or by
- selective dissolution of the primary structure.

23. A process according to either of claims 13 and 17, characterized by
- separation of the microstructured layer of electrodeposited metal from the secondary structure by
- lifting-off of the structured metal layer from the secondary structure, or
- selective dissolution of the top layer of conductive material and of the parts of the solidified flowable material which the primary structure has filled.

## Revendications

1. Procédé de fabrication d'un corps à microstructure en matière plastique ou en matière frittée en moulant sur une garniture de moule, microstructurée,
selon lequel
on remplit la garniture de moule d'une matière fluide, non conductrice électrique, et on recouvre,
on fait solidifier la matière fluide et on sépare la matière fluide solidifiée de la garniture de moule, microstructurée, et on obtient l'organe à microstructure,
caractérisé en ce qu'
on utilise une garniture de moule (structure primaire) avec des cavités ouvertes d'un côté, en le réalisant dans un corps solide auquel on donne une microstructure (sans appliquer de lithographie profonde aux rayons X) et dont la structure est complémentaire de la structure du corps à microstructure.

2. Procédé selon la revendication 1,
caractérisé en ce qu'
- on utilise une garniture de moule à microstructure (structure primaire) en métal, céramique, verre ou pierre, de préférence en silicium, quartz, arséniure de gallium ou germanium, comme corps solide que l'on réalise,
- par mise en structure soustractive à l'aide d'un enlèvement sur modèle de matière tel qu'un usinage mécanique fin de précision, un usinage par un laser, une attaque par des ions ou une attaque anisotrope,
- ou par mise en structure additive par application selon le modèle de matière tel que le dépôt physique ou chimique de matière provenant de la phase gazeuse sur le corps solide,
- ou par mise en structure additive ou soustractive.

3. Procédé selon l'une des revendications 1 et 2,
caractérisé en ce qu'
- on remplit et on recouvre la structure primaire avec une résine réactive ou avec une matière plastique fondue constituant la matière fluide et
- on laisse solidifier la résine réactive par durcissement ou la matière plastique fondue par refroidissement.

4. Procédé selon les revendications 1 et 2,
caractérisé en ce qu'
- on remplit et on recouvre la structure primaire avec une matière pulvérulente, de préférence une céramique ou une poudre de verre ou par une barbotine qui contient l'une de ces poudres,
- on fait durcir la matière pulvérulente ou la barbotine par séchage, frittage ou cuisson.

5. Procédé selon l'une des revendications 1 à 4,
caractérisé en ce qu'
on sépare la matière fluide solidifiée de la structure primaire par
- soulèvement de la matière fluide solidifiée par rapport à la structure primaire ou
- dissolution sélective de la structure primaire.

6. Procédé selon l'une des revendications 1 à 5,
caractérisé par
enlèvement de la couche recouvrant la structure Primaire après séparation de la matière fluide solidifiée par rapport à la structure primaire, le corps à microstructure étant en matière plastique ou en matière frittée avec des orifices traversants.

7. Procédé selon la revendication 1 pour fabriquer des corps à microstructure en métal ou en matière frittée par moulage d'une garniture de moule pour obtenir un corps à microstructure dont la structure correspond à la structure de la garniture de moule,
caractérisé par les étapes suivantes appliquées après la solidification de la matière fluide non conductrice d'électricité dans la structure primaire,
- enlèvement de la couche recouvrant la structure primaire jusqu'à la face frontale de la structure primaire,
- application d'une couche de revêtement en matière conductrice qui est en contact avec la face frontale de la structure primaire,
- séparation de la matière fluide solidifiée avec la couche de recouvrement par rapport à la structure primaire pour donner une microstructure (structure secondaire) complémentaire de la structure primaire,
- remplissage et recouvrement de la structure secondaire avec un métal ou une matière frittée et solidification de la matière frittée.

8. Procédé selon la revendication 7,
caractérisé par
- l'utilisation d'une garniture de moule à microstructure (structure primaire) en métal, de préférence en laiton, aluminium ou acier, comme corps solide, que l'on a réalisée,
- par mise en structure soustractive en enlevant de la matière selon le modèle, par un usinage mécanique fin de précision ou un usinage par laser, une attaque par ions ou une attaque anisotrope,
- ou par une mise en structure additive en appliquant selon le modèle de la matière par dépôt physique ou chimique de matière à partir de la phase vapeur sur le corps solide,
- ou par mise en structure additive ou soustractive.

9. Procédé selon les revendications 7 et 8,
caractérisé en ce qu'
- on remplit et on recouvre la structure primaire avec une résine réactive ou avec une matière plastique fondue constituant la matière fluide et
- on laisse solidifier la résine réactive par durcissement ou la matière plastique fondue par refroidissement.

10. Procédé selon les revendications 7 ou 8,
caractérisé en ce qu'
- on remplit et on recouvre la structure primaire avec une matière pulvérulente - de préférence une céramique ou une poudre de verre - ou avec une barbotine contenant l'une de ces poudres,
- on laisse solidifier la matière pulvérulente ou la barbotine par séchage, frittage ou cuisson.

11. Procédé selon l'une des revendications 7 à 10,
caractérisé en ce qu'
- on sépare la matière fluide solidifiée de la structure primaire par
- soulèvement de la matière fluide solidifiée par rapport à la structure primaire ou par
- dissolution sélective de la structure primaire.

12. Procédé selon les revendications 7 à 11,
caractérisé en ce qu'
- on sépare la couche à microstructure du métal déposé par rapport à la structure secondaire par
- soulèvement de la couche métallique structurée par rapport à la structure secondaire ou
- par dissolution sélective de la couche de recouvrement de matière conductrice et de parties de la matière fluide solidifiée ayant rempli la structure primaire.

13. Procédé selon la revendication 12,
caractérisé en ce qu'
- on utilise une garniture de moule (structure primaire) en métal, de préférence en laiton, aluminium ou acier, avec des cavités ouvertes d'un côté, qui a été réalisée par une mise en structure soustractive par enlèvement de matière selon le modèle.

14. Procédé selon les revendications 12 et 13,
caractérisé en ce qu'
- on utilise une garniture de moule (structure primaire) en métal, de préférence en laiton, aluminium ou acier, avec des cavités ouvertes d'un côté, que l'on a réalisée
- par un usinage mécanique fin de précision tel que sciage, meulage, fraisage, perçage.

15. Procédé selon les revendications 12 et 13,
caractérisé en ce qu'
- on utilise une garniture de moule (structure primaire) en métal, de préférence en laiton, aluminium ou acier, avec des cavités ouvertes d'un côté, que l'on a réalisée
- par attaque ionique ou par attaque anisotrope d'une matière monocristalline constituant le corps solide.

16. Procédé selon les revendications 12 et 13,
caractérisé en ce qu'
- on utilise une garniture de moule (structure primaire) en métal, de préférence en laiton, aluminium ou acier, avec des cavités ouvertes d'un côté, que l'on a réalisée
- par un usinage par laser.

17. Procédé selon la revendication 12,
caractérisé en ce qu'
- on utilise une garniture de moule (structure primaire) en métal, de préférence en laiton, aluminium ou acier, avec des cavités ouvertes d'un côté, que l'on a réalisée par mise en structure additive par application de matière selon le modèle.

18. Procédé selon les revendications 12 et 17,
caractérisé en ce qu'
- on utilise une garniture de moule (structure primaire) en métal, de préférence en laiton, aluminium ou acier, avec des cavités ouvertes d'un côté, que l'on a réalisée par dépôt physique ou chimique de matière à partir de la phase vapeur d'un corps solide.

19. Procédé selon les revendications 12 et 17,
caractérisé en ce qu'
- on utilise une garniture de moule (structure primaire) en métal, de préférence en laiton, aluminium ou acier, avec des cavités ouvertes d'un côté, que l'on a réalisée par mise en structure additive et soustractive.

20. Procédé selon les revendications 13 et 17,
caractérisé en ce qu'
- on remplit et on recouvre la structure primaire avec une résine réactive ou avec de la matière plastique fondue constituant la matière fluide et
- on laisse solidifier la résine réactive par prise et la matière plastique fondue par refroidissement.

21. Procédé selon les revendications 13 et 17,
caractérisé en ce qu'
- on remplit et on recouvre la structure primaire d'une matière pulvérulente, de préférence d'un métal, d'une poudre céramique ou d'une poudre de verre ou d'une barbotine contenant l'une de ces poudres,
- on laisse solidifier la matière pulvérulente ou la barbotine par séchage, frittage ou cuisson.

22. Procédé selon les revendications 13 et 17,
caractérisé en ce qu'
- on sépare la matière fluide solidifiée par rapport à la structure primaire par
- soulèvement de la matière fluide solidifiée par rapport à la structure primaire ou par
- dissolution sélective de la structure primaire.

23. Procédé selon les revendications 13 et 17,
caractérisé en ce qu'
- on sépare la couche à microstructure du métal déposé par voie galvanique par rapport à la structure secondaire par
- soulèvement de la couche métallique mise en structure par rapport à la structure secondaire ou
- dissolution sélective de la couche de recouvrement de matière conductrice et de parties de la matière fluide solidifiée ayant rempli la structure primaire.
